# DEMANDE DE BREVET EUROPEEN

(11) **EP 3 678 162 A1**
(43) Date de publication de la demande: **08.07.2020**
(21) Numéro de dépôt: 19150602.1
(22) Date de dépôt: 07.01.2019
(51) Int. Cl.: H01L 21/02

(54) **HETERO-STRUCTURE DE SILICIUM/GERMANIUM**

(71) Demandeur: Universite d'Aix-Marseille (AMU), 13284 Marseille Cedex 07 (FR); CENTRE NATIONAL DE LA RECHERCHE SCIENTIFIQUE - CNRS, 75794 Paris Cedex 16 (FR); Université de Toulon, 83957 La Garde Cedex (FR)
(72) Inventeur: BERBEZIER, Isabelle, 13009 Marseille (FR); FAVRE, Luc, 13013 Marseille (FR); RONDA, Antoine, 13014 Marseille (FR)
(74) Mandataire: Macquet, Christophe

(57) **Abrégé**

L'invention concerne une hétéro-structure comprenant successivement une première couche de silicium, une seconde couche d'oxyde de silicium, et une couche Si_{1-Y}Ge_{Y} d'un alliage silicium-germanium présentant une épaisseur E, caractérisée en ce que Y est sensiblement constant dans ladite couche d'alliage, supérieure à 0 et inférieur ou égal à 1, en ce que ladite couche d'alliage est partiellement ou totalement relaxée, et en ce que son épaisseur E est d'au moins 5 nm. L'invention concerne également un procédé d'obtention d'une telle hétéro-structure, un procédé de préparation d'une telle hétéro-structure et son utilisation pour la fabrication de composants électroniques.

## Description

### DOMAINE DE L'INVENTION

La présente invention concerne une nouvelle hétéro-structure présentant une couche de surface en alliage silicium (Si) - germanium (Ge) d'épaisseur et de contrainte mécanique contrôlées. L'invention concerne également un procédé de préparation d'une telle hétéro-structure ainsi que son utilisation dans le domaine des semi-conducteurs.

### ART ANTERIEUR

La microélectronique désigne l'ensemble des technologies de fabrication de composants qui utilisent des courants électriques pour transmettre, traiter ou stocker des informations. Dans ce domaine, on connait notamment les structures à base de silicium sur isolant (ou en anglais *Silicium On Insulator* (SOI)), constituées d'un empilement d'une couche de silicium sur une couche d'isolant tel que le dioxyde de silicium (SiO₂). Ces structures sont plus particulièrement utilisées dans la préparation de composants électroniques appelés CMOS (ou en anglais *Complementary Metal Oxide Semiconductor*). De nombreux composants ont été réalisés en technologie intégralement en silicium. Cependant, les compromis à obtenir pour augmenter la vitesse des porteurs tout en maintenant un gain correct, ont rapidement limité les performances atteignables. Afin de surmonter cette limitation, différents types d'hétéro-structures ont été envisagées tels que, par exemple, les hétéro-structures à base de Silicium-Germanium (SiGe). De telles hétéro-structures font intervenir une couche de SiGe déposée sur un substrat de type SOI.

Une difficulté majeure intervenant lors de la préparation des hétéro-structures à base de SiGe est due au désaccord de maille entre le silicium (Si) présent sur le SOI et la couche de SiGe déposée. En effet, et ainsi que cela est montré dans le Tableau 1 ci-dessous, l'atome de Ge possède un rayon atomique (rayon de Van der Waals) légèrement plus grand que celui de l'atome de silicium.

**Tableau 1 : Paramètres des atomes des cristaux de Si et Ge massifs.**

| | Silicium | Germanium |
|---|---|---|
| Rayon atomique (nm) | 0,132 | 0,137 |
| Paramètre de maille (nm) | 0,543 | 0,566 |

Ce désaccord de maille existant entre le Si et la couche SiGe est donc à l'origine de la relaxation éventuelle de l'alliage SiGe sur Si :
- soit le réseau du film SiGe est en compression pour s'aligner sur le réseau Si du substrat SOI ;
- soit le réseau du film SiGe se relaxe en créant des défauts structuraux à l'interface Si/SiGe, ou dans la couche SiGe.

Parmi les défauts qu'il est possible de rencontrer lors de la préparation des hétéro-structures à base de SiGe, on peut noter :
- les dislocations d'interface ;
- les dislocations traversantes ;
- les défauts d'empilement ;
- les joints de grain ; et
- la croissance d'îlots sur la surface, en lieu et place d'une couche plane continue.

Les dislocations sont des défauts cristallins importants et intolérables dans les couches actives d'un dispositif électronique. Les défauts ou dislocations n'apparaissent, en général, qu'à l'interface Si/SiGe, mais peuvent également se propager dans le volume de la couche de surface de SiGe.

La qualité de surface de la couche active d'un matériau semi-conducteur est donc d'une très grande importance. Plus précisément, la rugosité, ainsi que l'absence de défauts à la surface de cette couche active, sont des paramètres qui doivent être optimisés, pour que les futurs composants réalisés à partir de ces hétéro-structures soient d'une qualité optimale.

Ainsi, pour obtenir des semi-conducteurs de plus en plus performants, il devient indispensable de réaliser des hétéro-structures présentant une couche de SiGe d'excellente qualité cristalline. En effet, si la couche de SiGe est contrainte, il n'y a pas de dislocations dans le matériau mais la couche de Si épitaxiée sur ladite couche de SiGe n'est alors pas contrainte et l'augmentation de vitesse des porteurs n'est alors plus assurée. A l'inverse, si la couche de SiGe est relaxée, la couche de Si épitaxiée est alors contrainte et l'augmentation de vitesse des porteurs est assurée. Néanmoins, dans ce dernier cas, la densité de dislocations liée à la relaxation, risque (i) d'être élevée dans la couche de SiGe, et (ii) de se propager dans la couche de Si ce qui contreviendrait aux bonnes propriétés du semi-conducteur par la suite.

Parmi les solutions employées, la plus répandue consiste à utiliser des substrats à gradient de composition. Ces derniers sont formés d'une couche SiGe dont la composition en germanium s'enrichit graduellement en s'approchant de la surface. Cette structure permet de piéger une grande quantité de dislocations dans la couche elle-même. Néanmoins, cette technique présente deux inconvénients majeurs : la couche SiGe est épaisse (plusieurs microns) et la densité de dislocation reste dommageable aux propriétés électronique de la couche de silicium déposée par la suite.

L'utilisation d'une couche SiGe de composition contrôlée, relaxée, et contenant une faible densité de défauts, est également un élément important pour l'élaboration d'hétérostructures III-V. Les alliages de composés III-V présentent des propriétés électroniques fondamentales en microélectronique mais leur utilisation est limitée par la difficulté d'intégration de ces matériaux dans les composants basés sur silicium. La différence de paramètre de maille entre alliages III-V et le silicium explique l'émergence de contraintes mécaniques fortes. Ces dernières engendrent une grande densité de défauts structuraux dans les couches III-V, dégradant fortement leurs propriétés électroniques.

L'utilisation d'alliages Si-Ge, de paramètre de maille plus grand que celui du silicium pur, permet de réduire les contraintes mécaniques. Ces derniers doivent pouvoir être intégrés sur des SOI sous forme de couches fines, de composition contrôlée et présentant une faible densité de défauts.

Dans ce contexte, il apparaît que la préparation d'hétéro-structures SOI présentant une couche de SiGe, au choix, contrainte ou relaxée en surface, de faible épaisseur, et présentant une très faible densité de dislocations, est fondamentale pour la préparation de composants électroniques ayant de bonnes propriétés électroniques.

### RESUME DE L'INVENTION

Selon un premier objet, l'invention concerne une hétéro-structure comprenant successivement une première couche de silicium, une seconde couche d'oxyde de silicium, et une couche Si₁-_{Y}Ge_{Y} d'un alliage silicium-germanium présentant une épaisseur E, caractérisée en ce que Y est sensiblement constant dans ladite couche d'alliage, supérieur à 0 et inférieur ou égal à 1, en ce que ladite couche d'alliage est au moins partiellement relaxée, et en ce que son épaisseur E est d'au moins 5 nm.

Avantageusement, - la couche d'alliage silicium-germanium présente une densité de défauts structuraux inférieure à 10⁸/cm³ ; - Y est strictement supérieur à 0,5 et est strictement inférieur à 1 ; - Y est strictement supérieur à 0 et strictement inférieur à 0,5 ; - l'épaisseur de la couche de surface de Si₁-_{Y}Ge_{Y} est inférieure à 20 nm ; - l'hétéro-structure comprend une couche additionnelle d'un alliage de silicium-germanium Si_{1-z}Ge_{z} dans laquelle Z est sensiblement constant dans la couche additionnelle, et Z différent de Y, ladite couche additionnelle étant contrainte en tension biaxiale dans deux directions (x,y) parallèles au plan de ladite couche, ou contrainte en compression biaxiale dans deux directions (x,y) parallèles au plan de ladite couche ; - l'hétéro-structure comprend une couche additionnelle de silicium contrainte en tension biaxiale dans deux directions (x,y) ; - l'hétéro-structure comporte une couche additionnelle d'un alliage de type III-V ou II-VI non contrainte en tension, ou contrainte en tension biaxiale, dans deux directions (x,y) parallèles au plan de la couche, ou contrainte en compression ; et - l'alliage est un alliage III-V sélectionné parmi le groupe consistant en GaAs, GaSb, InP, InAs et InSb.

Par ailleurs, selon un second objet, l'invention concerne un procédé de préparation d'une hétéro-structure selon l'une quelconque des revendications précédentes, comprenant les étapes : i) réaliser une croissance par épitaxie, à une température comprise entre 300°C et 600°C, d'une couche Si_{1-X}Ge_{X} d'un alliage silicium-germanium sur un substrat comprenant successivement une première couche de silicium et une seconde couche d'oxyde de silicium, X étant compris entre 0,0001 et 0,5 ; ii) réaliser une oxydation partielle ou complète de la couche obtenue à l'étape i), à une température comprise entre 700°C et 900°C, pendant une durée comprise entre 30 min et 16h, pour former, d'une part, une couche en compression Si_{1-Y}Ge_{Y} d'un alliage silicium-germanium dans laquelle Y est supérieur à 0 et inférieur ou égal à 1 et, d'autre part, une couche d'oxyde de silicium en surface ; et iii) réaliser un traitement acide de la couche de surface d'oxyde de silicium en surface obtenue à l'étape ii) pour obtenir, en surface, l'hétéro-structure comportant une couche de surface Si_{1-Y}Ge_{Y} en alliage silicium-germanium contrainte en compression.

Avantageusement, - l'oxydation de la couche obtenue à l'étape i) est complète et en ce que Y est strictement supérieur à 0,5 et est strictement inférieur à 1 ; - l'oxydation de la couche obtenue à l'étape i) est partielle et en ce que Y est strictement supérieur à 0 et strictement inférieur à 0,5 ; le procédé - comprend en outre une étape de : recuit de l'hétéro-structure obtenue selon iii), sous vide, à une pression inférieure à 10⁻³ mbar et à une température comprise entre 600°C et 800°C, pour obtenir une hétéro-structure dont la couche de surface Si_{1-Y}Ge_{Y} en alliage silicium-germanium est au moins partiellement relaxée ; - comprend en outre l'étape : croissance par épitaxie d'une couche additionnelle d'un alliage de silicium-germanium Si_{1-z}Ge_{z} dans laquelle Z est sensiblement constant dans la couche additionnelle, et différent de Y, ladite couche additionnelle étant contrainte en tension biaxiale dans deux directions (x,y) parallèles au plan de ladite couche, ou contrainte en compression ou en compression biaxiale dans deux directions (x,y) parallèles au plan de ladite couche ; - comprend en outre l'étape : croissance par épitaxie d'une couche additionnelle de silicium contrainte en tension biaxiale dans deux directions (x,y) ; - comprend en outre l'étape : croissance par épitaxie d'une couche additionnelle d'un alliage de type III-V non contrainte en tension, ou contrainte en tension biaxiale, dans deux directions (x,y) parallèles au plan de la couche, ou contrainte en compression ; et - l'alliage III-V est sélectionné parmi le groupe consistant en GaAs, GaSb, InP, InAs et InSb.

Enfin, selon un troisième objet, l'invention concerne l'hétéro-structure telle que définie ci-dessus pour la fabrication de composants électronique.

### DESCRIPTION DETAILLEE DE L'INVENTION

L'invention concerne une hétéro-structure comprenant successivement une première couche de silicium, une seconde couche d'oxyde de silicium, et une couche de surface de Si_{1-Y}Ge_{Y} en alliage silicium-germanium, ladite hétéro-structure étant utilisée notamment, pour la fabrication de composants électroniques.

La couche de surface Si_{1-Y}Ge_{Y} est au moins partiellement sinon totalement relaxée. La valeur Y est contrôlée. Elle est sensiblement constante dans la couche de surface. Y est supérieur et inférieur ou égal à 1. Dans un mode de réalisation Y est supérieur ou égal à 0,5 et est inférieur ou égal à 1. Dans un autre mode de réalisation, Y est strictement supérieur à 0 et strictement inférieur à 0,5. Dans cet autre mode de réalisation, de manière préférée, Y est supérieur ou égal à 0,2.

La couche d'alliage silicium-germanium présente une épaisseur E. Cette épaisseur est comprise entre quelques nanomètres et peut atteindre 1 micron. Elle est d'au moins 5 nm. Elle est préférentiellement inférieure à 20 nm. L'épaisseur de la couche d'alliage est contrôlée selon la valeur d'Y compris entre 0 et 1. Elle dépend de la concentration en germanium. Par exemple, la valeur d'épaisseur de 5 nm est obtenue dans le cas favorable où la valeur Y est égale ou de l'ordre de 0,5. L'épaisseur de la couche d'oxyde de silicium est contrôlée indépendamment des autres paramètres caractéristiques de l'hétéro-structure. Elle est comprise entre quelques nanomètres et plusieurs microns.

La surface de la couche d'alliage silicium-germanium est plane. Elle présente une faible densité de défauts structuraux. Cette densité est inférieure à 10⁸/cm³.

Dans le contexte de l'invention, on emploie les termes de valeur « sensiblement constante » pour qualifier la répartition spatiale des atomes de Ge liés à la valeur X, Y ou Z dans les couches, Si_{1-X}Ge_{X} et/ou Si_{1-Y}Ge_{Y} et/ou Si_{1-Z}Ge_{Z}. Plus précisément, « sensiblement constant » signifie que la valeur X et/ou Y et/ou Z est répartie de manière homogène dans l'ensemble de la couche Si_{1-X}Ge_{X} et/ou Si_{1-Y}Ge_{Y} et/ou Si_{1-Z}Ge_{Z}. Autrement dit encore, les atomes de Ge ont une répartition homogène dans l'ensemble de la couche de SiGe, c'est-à-dire une répartition de façon à optimiser les interactions du type covalent entre les atomes de Si/Ge et Ge/Ge et Si/Si.

Dans le contexte de l'invention, on utilise le terme de couche dite « relaxée », lorsque la couche présente, dans son volume, un paramètre de maille similaire à son paramètre de maille nominal. Le paramètre de maille nominal est le paramètre de maille du matériau sous sa forme massive à l'équilibre. A l'inverse, on appelle couche « contrainte » toute couche d'un matériau cristallin dont la structure cristalline est contrainte élastiquement en tension ou en compression, obligeant son paramètre de maille à être sensiblement différent du paramètre de maille nominal de ce matériau sous sa forme massive. Les termes "partiellement relaxée" désignent un état où la couche est relaxée mais pas totalement. A contrario, la couche est alors "partiellement contrainte". Les termes "au moins partiellement relaxée" désignent des états où la couche est partiellement relaxée ou totalement relaxée.

Dans le contexte de la présente invention, tous les intervalles de valeurs divulgués doivent être interprétés comme incluant les bornes de valeurs inférieures et supérieures des dits intervalles, à moins qu'il en soit spécifiquement stipulé l'inverse. Dans un autre mode de réalisation préféré, l'épaisseur de la couche de surface de Si_{1-Y}Ge_{Y} de l'hétéro-structure est inférieure à 20 nm.

Selon un mode de réalisation de l'invention, l'hétéro-structure comprend une couche additionnelle d'un alliage de silicium-germanium Si_{1-z}Ge_{z} dans laquelle Z est sensiblement constant dans la couche additionnelle, différent de y, ladite couche additionnelle étant contrainte en tension biaxiale dans deux directions (x,y) parallèles au plan de ladite couche, ou contrainte en compression biaxiale dans deux directions (x,y) parallèles au plan de ladite couche. La structure cristalline de la couche Si_{1-Y}Ge_{Y} permet une reprise d'épitaxie avec une couche d'alliage Si_{1-z}Ge_{z.} On notera alors que la surface de la couche Si_{1-Y}Ge_{Y} présente une très faible concentration de défauts structuraux. Le paramètre de maille de la couche Si_{1-Y}Ge_{Y} est ajustable grâce à la concentration Y en germanium et permet de choisir la nature (tension ou compression) et l'intensité de la contrainte biaxiale, dans deux directions (x,y) parallèles au plan de la couche, induite dans la couche d'alliage Si_{1-z}Ge_{z}. L'épaisseur de la couche Si_{1-Y}Ge_{Y} est contrôlée. Sa faible épaisseur peut permettre un partage des contraintes en présence d'une différence de paramètre de maille avec l'alliage Si_{1-z}Ge_{z} et faciliter la reprise d'épitaxie.

Selon un autre mode de réalisation selon l'invention, l'hétéro-structure comporte une couche additionnelle de silicium contrainte en tension biaxiale dans deux directions (x,y). La structure cristalline de la couche Si_{1-Y}Ge_{Y} permet en effet une reprise d'épitaxie avec une couche de silicium. On notera alors que la surface de la couche Si_{1-Y}Ge_{Y} présente une très faible concentration de défauts structuraux. Le paramètre de maille de la couche Si_{1-Y}Ge_{Y} est ajustable grâce à la concentration Y en germanium et permet de choisir la contrainte en tension biaxiale, dans deux directions (x,y) parallèles au plan de la couche, induite dans la couche de silicium. L'épaisseur de la couche Si_{1-Y}Ge_{Y} est contrôlée. Sa faible épaisseur peut permettre un partage des contraintes en présence d'une différence de paramètre de maille avec le silicium et faciliter la reprise d'épitaxie.

Selon un autre mode de réalisation selon l'invention encore, l'hétéro-structure comporte une couche additionnelle d'un alliage de type III-V non contrainte en tension, ou contrainte en tension biaxiale, dans deux directions (x,y) parallèles au plan de la couche, ou contrainte en compression. La structure cristalline de la couche Si_{1-Y}Ge_{Y} permet effectivement une reprise d'épitaxie avec une couche d'alliage de type III-V. On notera alors que la surface de la couche Si_{1-Y}Ge_{Y} présente une très faible concentration de défauts structuraux. Le paramètre de maille de la couche Si_{1-Y}Ge_{Y} est ajustable grâce à la concentration Y en germanium et permet de choisir si la couche d'alliage de type III-V sera non contrainte, ou contrainte en tension bi-axiale, ou en compression bi-axiale, dans deux directions (x,y) parallèles au plan de la couche. L'épaisseur de la couche Si_{1-Y}Ge_{Y} est contrôlée. Sa faible épaisseur peut permettre un partage des contraintes en présence d'une différence de paramètre de maille avec l'alliage de type III-V et faciliter la reprise d'épitaxie. De manière avantageuse, l'hétéro-structure l'alliage III-V est sélectionné parmi le groupe consistant en GaAs, GaSb, InP, InAs et InSb.

Selon un deuxième objet, l'invention concerne un procédé de préparation d'une hétéro-structure telle que décrite ci-dessus. Ce procédé comprend une première étape i) dans laquelle on réalise une croissance par épitaxie. L'épitaxie est une technique de croissance orientée, l'un par rapport à l'autre, de deux cristaux possédant un certain nombre d'élément de symétrie communs dans leurs réseaux cristallins. L'épitaxie est utilisée pour faire croître des couches minces, de quelques nanomètres d'épaisseur jusqu'à plusieurs microns. Pour cela des atomes sont déposés sur la surface parfaitement plane d'un monocristal, le substrat. Il existe plusieurs techniques d'épitaxie. L'épitaxie par jet moléculaire s'effectue sous ultra vide. Les éléments à déposer sont évaporés à haute température et vont se déposer par transport balistique sur la surface du substrat, qui est, elle, à une température légèrement inférieure pour permettre la diffusion et le réarrangement des atomes adsorbés. L'épitaxie en phase liquide consiste à mettre un substrat, par exemple SOI, en contact avec une phase liquide saturée en élément dont il est souhaité la croissance. Cet élément précipite et cristallise sur le substrat. L'épitaxie en phase vapeur (ou en anglais Vapor Phase Epitaxy (VPE) ou Chemical Vapor Deposition (CVD)), quant à elle, implique une croissance à partir d'une phase mère gazeuse suivi d'une réaction chimique et/ou de condensation à l'équilibre ou hors équilibre, pour l'obtention d'un cristal.

Dans le cadre de l'invention, une épitaxie par jet moléculaire, ou en phase vapeur, est réalisée à une température comprise entre 300°C et 600°C, d'une couche de Si₁₋ₓGeₓ sur un substrat comprenant successivement une première couche de silicium et une seconde couche d'oxyde de silicium, X étant compris entre 0,0001 et 0,5.

Dans une seconde étape ii) du procédé, on réalise une oxydation de la couche obtenue à l'étape i), à une température comprise entre 700°C et 900°C. L'oxydation est maintenue pendant une durée comprise entre 30 min et 16h, pour former une couche de surface de Si_{1-Y}Ge_{Y}, enrichie en germanium, dans laquelle Y est supérieur ou égal à 0 et inférieur ou égal à 1, et sensiblement constant dans ladite couche de surface. L'oxydation de la couche obtenue à l'étape i) peut être partielle ou complète. Si elle est complète alors Y est supérieur à 0,5 et est inférieur ou égale à 1. Si elle est partielle alors Y est strictement supérieur à 0 et strictement inférieur à 0,5.

À titre d'exemples, pour une couche de silicium de 12 nm, sur laquelle a été déposée une couche initiale Si_{1-X}Ge_{X} de 34 nm, avec X=0,2, et oxydée à une température de 750°C, lorsque la durée d'oxydation est inférieure à 13h, la valeur de Y dans la couche de surface Si_{1-Y}Ge_{Y} est sensiblement constante et Y est d'au moins 0,5. Lorsque la durée d'oxydation est comprise entre 13h et 14h, la valeur de Y dans la couche de surface Si_{1-Y}Ge_{Y} est sensiblement constante et Y est strictement supérieur à 0,5 et inférieur ou égal à 0,7. Lorsque la durée d'oxydation est supérieure à 14h, la valeur de Y dans la couche de surface Si_{1-Y}Ge_{Y} est sensiblement constante et Y est strictement supérieur à 0,7 et strictement inférieur à 1.

Pendant l'étape d'oxydation, il y a deux mécanismes en compétition. Le premier mécanisme implique l'incorporation d'atome d'oxygène (O) à l'intérieur de la couche de Si_{1-X}Ge_{X}, et plus préférentiellement au niveau des liaisons Si-Si. Le deuxième mécanisme implique la diffusion du Ge à travers la couche de Si_{1-X}Ge_{X}. Durant ce mécanisme, les atomes de Ge qui restent non liés à des atomes d'oxygènes sont repoussés en dessous de la nouvelle interface Si_{1-X}Ge_{X}/SiO₂ se formant, et formant ainsi une nouvelle couche Si_{1-Y}Ge_{Y} enrichie en Ge, en épitaxie sur la couche Si_{1-X}Ge_{X} et contrainte en compression. Le maintien d'une température inférieure à 900°C limite la diffusion des atomes de Ge à l'intérieur de la couche Si_{1-X}Ge_{X}, permettant de réduire l'extension de la nouvelle couche de Si₁-_{Y}Ge_{Y} enrichie en Ge alors que le taux d'incorporation d'atome d'oxygène dans la couche Si_{1-X}Ge_{X} reste élevé. Durant l'oxydation, il y a cohabitation entre la couche Si_{1-X}Ge_{X} dont l'épaisseur diminue, et la couche Si_{1-Y}Ge_{Y} enrichie en Ge, dont l'épaisseur augmente. Dans ce cas, de manière préférentielle, Y est supérieur ou égal 0,5 et inférieur ou égal à 1. À des températures supérieures à 900°C, la diffusion des atomes de Ge à travers la couche de Si_{1-X}Ge_{X} devient très facile et permet une homogénéisation de la concentration en germanium. La couche Si_{1-X}Ge_{X} s'enrichit globalement pour donner une couche Si_{1-Y}Ge_{Y} durant l'oxydation. Dans ce cas, de manière préférentielle, Y est supérieur ou égal X et inférieur ou égal à 1.

Dans une troisième étape iii) du procédé, on réalise un traitement par acide fluorhydrique de la couche d'oxyde de silicium SiO₂ de surface obtenue à l'étape ii) pour supprimer cette couche et obtenir une hétéro-structure Si₁-_{Y}Ge_{Y} contrainte en compression, sans oxyde de silicium en surface.

Dans une quatrième étape iv) du procédé, on réalise un recuit, sous vide, à une pression inférieure à 10⁻³ mbar et à une température comprise entre 600°C et 800°C, de l'hétéro-structure contrainte en compression obtenue à l'étape iii). Le recuit permet de relaxer la couche d'alliage silicium-germanium au moins partiellement sinon totalement.

L'hétéro-structure telle que décrite ci-dessus peut être utilisée comme support pour la croissance par épitaxie d'une couche additionnelle de Si contrainte en tension bi-axiale dans deux directions (x,y) parallèles au plan de la couche. De manière générale, sous l'effet d'une contrainte de tension bi-axiale, l'espacement entre les atomes de Si dans le plan est plus important que l'espacement dans le Si relaxé. Cette distorsion du réseau cristallin modifie les diagrammes de bandes électroniques du matériau dans le sens d'une amélioration de la mobilité des électrons et des trous, et donc augmente la vitesse de fonctionnement des composants électroniques. L'utilisation de couches SOI permet aux composants de fonctionner à des vitesses nettement plus importantes et avec des pertes électriques moindres. On estime que par rapport à des composants sur substrat massif de silicium, la réduction sur la puissance consommée est de 2 à 3 fois, et l'augmentation de vitesse est de 20 à 30%. De manière similaire, l'utilisation de couches contraintes de silicium résulte en une augmentation de vitesse de 20 à 30%.

Ainsi, l'hétéro-structure selon l'invention faisant notamment intervenir une couche d'un alliage de SiGe, permet de créer la contrainte dans la couche de Si subséquente. Les atomes de Ge étant plus gros que les atomes de Si, les distances inter-atomiques sont plus grandes de 4,2% dans un réseau de Ge que de Si, ce qui rend difficile un bon raccord de maille entre les deux réseaux. En constituant un alliage de SiGe avec des concentrations contrôlées en Ge, il est possible d'obtenir un réseau avec une distance inter-atomique plus élevée que celle du Si, mais qui reste suffisamment proche pour réaliser une épitaxie. Le degré de contrainte alors atteint dans la couche de Si est fonction de la concentration en Ge de la couche SiGe. En effet, plus la couche de SiGe est riche en Ge, plus il est difficile de réaliser une relaxation de ladite couche sans faire apparaître des densités de dislocations néfastes aux bonnes propriétés électroniques de l'hétéro-structure. Si la couche de SiGe se relaxe, la couche de Si épitaxiée est alors contrainte, l'augmentation de vitesse des porteurs est assurée. Grâce à la présente invention, la Demanderesse a surmonté les difficultés connues de l'art antérieur et a permis l'obtention d'une hétéro-structure présentant une couche mince de SiGe relaxée, tout en maintenant une densité de dislocation faible voire nulle dans ladite couche mince de SiGe pour améliorer les propriétés électroniques de l'hétéro-structure.

L'hétéro-structure telle que définie ci-dessus peut aussi être utilisée comme support pour la croissance par épitaxie d'une couche additionnelle d'alliage silicium-germanium, au choix : en tension bi-axiale dans deux directions (x,y) parallèles au plan de la couche, ou en compression bi-axiale dans deux directions (x,y) parallèles au plan de la couche. Les avantages attendus sont identiques à ceux du troisième objet, mais pour un couche SiGe contrainte, cette fois.

Elle peut être encore utilisée comme support pour la croissance par épitaxie d'une couche additionnelle d'un alliage de type III-V au choix : (i) non contrainte en tension, (ii) contrainte en tension bi-axiale, dans deux directions (x,y) parallèles au plan de la couche, (iii) en compression bi-axiale, dans deux directions (x,y) parallèles au plan de la couche. Les semi-conducteurs d'alliage III-V sont des matériaux composés d'un ou plusieurs éléments de la colonne III et de la colonne V du tableau périodique de Mendeleïev. Ils présentent généralement une haute mobilité électronique, et sont utilisés dans des applications optoélectroniques ainsi qu'électroniques. Contrairement au silicium qui est un matériau à bande interdite indirecte, de nombreux composés III-V présentent une structure à bande interdite directe tels que GaAs, InAs, pour lesquels le minimum de la bande de conduction et le maximum de la bande de valence se situent au centre de la zone de Brillouin (en *k*=0). Ces matériaux présentent des propriétés optiques remarquables :
- l'émission de photons par recombinaison « bande à bande » des porteurs en excès permet leur utilisation pour la fabrication de diodes lasers ou électroluminescentes ;
- le bon rendement de conversion de photons en électrons peut être utilisé dans la photodétection.

Dans le contexte de l'invention, l'alliage III-V est préférentiellement sélectionné parmi le groupe consistant en alliages binaires (BN, BP, Bas, AlN, AlP, AlAs, AlSb, GaN, GaP, GaAs, GaSb, InN, InP, InAs et InSb) et ternaires (AlGaAs, AlₓGa₁₋ₓAs, InGaAs, InₓGa₁₋ₓAs, InGaP, AlInAs, AlInSb, GaAsN, GaAsP, AlGaN, AlGaP, InGaN, InAsSb, et InGaSb). Les alliages ci-dessus peuvent être étendus aux alliages II-VI.

## Revendications

1. Hétéro-structure comprenant successivement une première couche de silicium, une seconde couche d'oxyde de silicium, et une couche Si₁-_{Y}Ge_{Y} d'un alliage silicium-germanium présentant une épaisseur E, **caractérisée en ce que** Y est sensiblement constant dans ladite couche d'alliage, supérieur à 0 et inférieur ou égal à 1, **en ce que** ladite couche d'alliage est au moins partiellement relaxée, et **en ce que** son épaisseur E est d'au moins 5 nm.

2. Hétéro-structure selon la revendication 1, **caractérisée en ce que** la couche d'alliage silicium-germanium présente une densité de défauts structuraux inférieure à 10⁸/cm³.

3. Hétéro-structure selon l'une quelconque des revendications précédentes, **caractérisée en ce que** Y est supérieur ou égal à 0,5 et est inférieur ou égal à 1.

4. Hétéro-structure selon l'une quelconque des revendications 1 ou 2, **caractérisée en ce que** Y est strictement supérieur à 0 et strictement inférieur à 0,5.

5. Hétéro-structure selon l'une quelconque des revendications précédentes, **caractérisé en ce que** l'épaisseur de la couche de surface de Si_{1-Y}Ge_{Y} est inférieure à 20 nm.

6. Hétéro-structure selon l'une quelconque des revendications précédentes, **caractérisée en ce qu'**elle comprend une couche additionnelle d'un alliage de silicium-germanium Si_{1-z}Ge_{z} dans laquelle Z est sensiblement constant dans la couche additionnelle, et différent de Y, ladite couche additionnelle étant
contrainte en tension biaxiale dans deux directions (x,y) parallèles au plan de ladite couche, ou
contrainte en compression biaxiale dans deux directions (x,y) parallèles au plan de ladite couche.

7. Hétéro-structure selon l'une quelconque des revendications 1 à 6, **caractérisée en ce qu'**elle comporte une couche additionnelle de silicium contrainte en tension biaxiale dans deux directions (x, y).

8. Hétéro-structure selon l'une quelconque des revendications 1 à 7, **caractérisée en ce qu'**elle comporte une couche additionnelle d'un alliage de type III-V
non contrainte en tension, ou
contrainte en tension biaxiale, dans deux directions (x,y) parallèles au plan de la couche, ou
contrainte en compression, dans deux directions (x,y) parallèles au plan de la couche.

9. Hétéro-structure selon la revendication 8, **caractérisée en ce que** l'alliage III-V est sélectionné parmi le groupe consistant en GaAs, GaSb, InP, InAs et InSb.

10. Procédé de préparation d'une hétéro-structure selon l'une quelconque des revendications précédentes, comprenant les étapes :
i) réaliser une croissance par épitaxie, à une température comprise entre 300°C et 600°C, d'une couche Si_{1-X}Ge_{X} d'un alliage silicium-germanium sur un substrat comprenant successivement une première couche de silicium et une seconde couche d'oxyde de silicium, X étant compris entre 0,0001 et 0,5 ;
ii) réaliser une oxydation partielle ou complète de la couche obtenue à l'étape i), à une température comprise entre 700°C et 900°C, pendant une durée comprise entre 30 min et 16h, pour former, d'une part, une couche Si_{1-Y}Ge_{Y} d'un alliage silicium-germanium dans laquelle Y est supérieur à 0 et inférieur ou égal à 1 et, d'autre part, une couche d'oxyde de silicium en surface ; et
iii) réaliser un traitement acide de la couche de surface d'oxyde de silicium en surface obtenue à l'étape ii) pour obtenir, en surface, l'hétéro-structure comportant une couche de surface Si_{1-Y}Ge_{Y} en alliage silicium-germanium contrainte en compression.

11. Procédé selon la revendication 10, **caractérisé en ce que** l'oxydation de la couche obtenue à l'étape i) est complète et **en ce que** Y est supérieur ou égal à 0,5 et est inférieur ou égal à 1.

12. Procédé selon la revendication 10, **caractérisé en ce que** l'oxydation de la couche obtenue à l'étape i) est partielle et **en ce que** Y est strictement supérieur à 0 et strictement inférieur à 0,5.

13. Procédé selon l'une des revendications 10 à 12, comprenant en outre une étape de :
réaliser un recuit de l'hétéro-structure obtenue selon iii), sous vide, à une pression inférieure à 10⁻³ mbar et à une température comprise entre 600°C et 800°C, pour obtenir une hétéro-structure dont la couche de surface Si_{1-Y}Ge_{Y} en alliage silicium-germanium est au moins partiellement relaxée.

14. Procédé selon l'une des revendications 10 à 13, comprenant en outre l'étape :
croissance par épitaxie d'une couche additionnelle d'un alliage de silicium-germanium Si_{1-z}Ge_{z} dans laquelle Z est sensiblement constant dans la couche additionnelle, différent de Y, ladite couche additionnelle étant
contrainte en tension biaxiale dans deux directions (x,y) parallèles au plan de ladite couche, ou
contrainte en compression biaxiale dans deux directions (x,y) parallèles au plan de ladite couche.

15. Procédé selon l'une des revendications 10 à 14, comprenant en outre l'étape :
croissance par épitaxie d'une couche additionnelle de silicium contrainte en tension biaxiale dans deux directions (x,y).

16. Procédé selon l'une des revendications 10 à 15, comprenant en outre l'étape :
croissance par épitaxie d'une couche additionnelle d'un alliage de type III-V ou II-VI
non contrainte en tension, ou
contrainte en tension biaxiale, dans deux directions (x,y) parallèles au plan de la couche, ou
contrainte en compression.

17. Procédé selon la revendication 16, **caractérisé en ce que** l'alliage est un alliage III-V, qui est sélectionné parmi le groupe consistant en GaAs, GaSb, InP, InAs et InSb.

18. Utilisation de l'hétéro-structure selon l'une quelconque des revendications 1 à 9 pour la fabrication de composants électroniques.
